# FASCICULE DE BREVET EUROPEEN

(11) **EP 3 469 112 B1**
(45) Date de publication et mention de la délivrance du brevet: **22.07.2020**
(21) Numéro de dépôt: 17783906.5
(22) Date de dépôt: 09.06.2017
(51) Int. Cl.: C23C 10/28, C23C 12/00, C23C 28/00

(54) **PROCÉDÉ DE PROTECTION CONTRE LA CORROSION ET L'OXYDATION D'UNE PIÈCE EN SUPERALLIAGE MONOCRISTALLIN À BASE DE NICKEL EXEMPT D'HAFNIUM**
VERFAHREN ZUM SCHUTZ EINES HAFNIUMFREIEN, EINKRISTALLINEN SUPERLEGIERUNGSTEIL AUF NICKELBASIS VOR KORROSION UND OXIDATION
METHOD FOR THE PROTECTION OF A HAFNIUM-FREE, NICKEL-BASED MONOCRYSTALLINE SUPERALLOY PART AGAINST CORROSION AND OXIDATION

(30) Priorité: 10.06.2016 FR 1655338
(43) Date de publication de la demande: 17.04.2019
(73) Titulaire: Safran, 75015 Paris (FR)
(72) Inventeur: SABOUNDJI, Amar, 77550 Moissy-Cramayel (FR); JAQUET, Virginie, 77550 Moissy-Cramayel (FR)
(74) Mandataire: Regimbeau
(86) Numéro de dépôt international: PCT/FR2017/051473
(87) Numéro de publication internationale: WO 2017/212193

(56) Documents cités:
- EP-A1- 0 718 420
- EP-A1- 0 821 078
- EP-A1- 1 010 774
- WO-A1-2012/146864
- US-A1- 2003 044 633

## Description

### DOMAINE TECHNIQUE GENERAL

L'invention se situe dans le domaine des superalliages monocristallins à base de nickel.

La présente invention concerne plus précisément un procédé de protection contre la corrosion et l'oxydation d'une pièce en superalliage monocristallin à base de nickel exempt d'hafnium.

### ETAT DE L'ART

Par "superalliages", on entend des alliages complexes présentant, à haute température et à haute pression, une très bonne résistance à l'oxydation, à la corrosion, au fluage et à des contraintes cycliques (notamment mécaniques ou thermiques). Ces superalliages trouvent une application particulière dans la fabrication de pièces utilisées dans l'aéronautique.

On connait déjà dans l'état de la technique, des pièces qui comprennent successivement de l'intérieur vers l'extérieur : un substrat en superalliage monocristallin à base de nickel, une sous-couche et une barrière thermique.

L'ajout d'hafnium est connu pour améliorer la résistance à la corrosion et à l'oxydation des superalliages, ainsi que l'adhérence de la barrière thermique.

Il existe plusieurs techniques pour ajouter du hafnium dans la pièce précitée.

Une première technique consiste à ajouter une faible quantité d'hafnium directement dans le substrat, c'est-à-dire pendant l'étape d'élaboration du superalliage constituant ce substrat. Toutefois, ceci rend plus difficile la mise en solution de ce superalliage.

Les superalliages subissent un traitement thermique, comportant une phase de mise en solution et des phases de revenus. De tels traitements consistent à chauffer l'alliage à une température appropriée, inférieure à la température eutectique et à maintenir cette température suffisamment longtemps pour homogénéiser les concentrations élémentaires de ses constituants et contrôler la taille des précipités intermétalliques. Ceci permet d'optimiser les propriétés microstructurales du matériau.

La présence d'hafnium dans le superalliage rend toutefois plus difficile la mise en solution totale ou quasi-totale des eutectiques et entraîne des défauts de type brûlure.

De plus, cette première technique ne permet pas d'améliorer l'adhérence de la barrière thermique sur le substrat, car la quantité d'hafnium contenue dans le superalliage est faible et que la quantité d'hafnium qui diffuse dans la sous-couche est encore plus faible. Toutefois, cette première technique permet d'améliorer la tenue à l'oxydation de la pièce ainsi obtenue.

Une deuxième technique consiste à ajouter du hafnium dans la sous-couche pendant le dépôt de celle-ci. Toutefois, cette technique permet uniquement d'améliorer l'adhérence de la barrière thermique sur le substrat. En effet, l'hafnium diffuse essentiellement dans les joints de grains de la sous-couche et de ce fait, ne permet pas d'améliorer la protection du substrat en superalliage contre la corrosion et contre l'oxydation.

Enfin, une troisième technique connue consiste à ajouter une faible quantité d'hafnium à la fois dans le substrat et pendant le dépôt de la sous-couche.

Toutefois, avec cette solution, on retrouve les mêmes problématiques que celles mentionnées pour la première technique.

Le document EP 1 010 774 A1 illustre par exemple un tel procédé de protection connu de l'art antérieur.

### PRESENTATION DE L'INVENTION

L'objectif de l'invention est donc de pallier les inconvénients précités de l'état de la technique.

L'invention a notamment pour objectif d'améliorer la protection vis-à-vis de la corrosion et de l'oxydation, des pièces réalisées en un superalliage monocristallin à base de nickel qui ne contient pas d'hafnium.

Par ailleurs, lorsque la pièce est recouverte d'une couche de barrière thermique, alors l'invention a également pour objectif d'améliorer l'adhérence de celle-ci sur la pièce et d'augmenter la durée de vie de l'ensemble de la pièce ainsi formée.

A cet effet, l'invention concerne un procédé de protection contre la corrosion et l'oxydation d'une pièce réalisée en superalliage monocristallin à base de nickel exempt d'hafnium.

Conformément à l'invention, ce procédé comprend au moins les étapes consistant à :
- fabriquer une pièce en superalliage monocristallin à base de nickel exempt d'hafnium,
- déposer, sur ladite pièce, une première couche comprenant de l''hafnium, puis une sous-couche d'un alliage comprenant au moins 10% atomique d'aluminium et une deuxième couche comprenant de l'hafnium, simultanément ou alternativement, de façon à former une couche mixte, et enfin une troisième couche comprenant de l'hafnium,
- faire diffuser ladite première couche comprenant de l''hafnium, de façon à former dans la partie supérieure de ladite pièce en superalliage monocristallin à base de nickel exempt d'hafnium, une première zone d'interdiffusion, et faire diffuser la troisième couche comprenant de l'hafnium, de façon à former à la surface de ladite couche mixte, une deuxième zone d'interdiffusion,
- après le traitement de diffusion, réaliser un traitement d'oxydation de ladite deuxième zone d'interdiffusion, de façon à obtenir une couche d'alumine dopée par de l'hafnium, à la surface de ladite deuxième zone d'interdiffusion.

Grâce à ces caractéristiques de l'invention, la pièce obtenue présente une meilleure résistance à la corrosion et à l'oxydation.

Selon d'autres caractéristiques avantageuses et non limitatives de l'invention, prises seules ou en combinaison :
- le procédé consiste à réaliser d'abord le dépôt des différentes couches et sous-couche, avant de procéder au traitement de diffusion,
- le procédé comprend au moins les étapes suivantes consistant à :
- fabriquer une pièce en superalliage monocristallin à base de nickel exempt d'hafnium,
- déposer, sur ladite pièce, une première couche comprenant de l''hafnium,
- faire diffuser cette première couche comprenant de l''hafnium, de façon à former à la surface de ladite pièce en superalliage monocristallin à base de nickel exempt d'hafnium, une première zone d'interdiffusion,
- déposer simultanément ou alternativement, sur ladite première zone d'interdiffusion, une sous-couche d'un alliage comprenant au moins 10% atomique d'aluminium et une deuxième couche comprenant de l'hafnium, de façon à former une couche mixte,
- déposer, sur ladite couche mixte, une troisième couche comprenant de l'hafnium,
- faire diffuser cette troisième couche comprenant de l'hafnium, de façon à former à la surface de ladite couche mixte, une deuxième zone d'interdiffusion,
- réaliser un traitement d'oxydation de ladite deuxième zone d'interdiffusion, de façon à obtenir une couche d'alumine dopée par de l'hafnium, à la surface de ladite deuxième zone d'interdiffusion,
- le procédé comprend une étape consistant à déposer, sur ladite couche d'alumine dopée par de l'hafnium, une couche de barrière thermique,
- au moins l'une des étapes de dépôt est réalisée par dépôt physique en phase vapeur PVD, de préférence par pulvérisation cathodique,
- le dépôt est réalisé par pulvérisation cathodique à une température comprise entre 100°C et 900°C, sous une pression comprise entre 0,1 Pa et 1Pa, avec une densité de puissance comprise entre 2 et 15 W/cm² et une polarisation négative comprise entre -150 V et -500 V et sous un bombardement ionique entre -200V et 500V pendant 10 à 30 minutes,
- le traitement de diffusion est réalisé par un traitement thermique sous vide ou en présence d'un mélange d'argon et de 5% en volume d'hélium, ce traitement thermique comprenant une étape de montée en température jusqu'à atteindre une température comprise entre 800°C et 1200°C, une étape de maintien de cette température pendant 1 heure à 4 heures et une étape de refroidissement par diminution de la température jusqu'à atteindre la température ambiante,
- le traitement d'oxydation de la deuxième zone d'interdiffusion (41) est réalisé par un traitement thermique sous pression partielle d'oxygène ou d'argon, ce traitement thermique comprenant une étape de montée en température jusqu'à atteindre une température comprise entre 900°C et 1200°C, une étape de maintien de cette température pendant moins d'une heure et une étape de refroidissement jusqu'à atteindre la température ambiante.

### PRESENTATION DES FIGURES

D'autres caractéristiques et avantages de l'invention apparaîtront de la description qui va maintenant en être faite, en référence aux dessins annexés, qui en représentent, à titre indicatif mais non limitatif, un mode de réalisation possible.

Sur ces dessins :
- les figures 1 à 8 sont des schémas représentant les différentes étapes d'un premier mode de réalisation du procédé conforme à l'invention, et
- les figures 9 à 15 sont des schémas représentant les différentes étapes d'un deuxième mode de réalisation du procédé conforme à l'invention.

### DESCRIPTION DETAILLEE

Les différentes étapes du procédé conforme à l'invention vont maintenant être décrites en faisant référence aux figures.

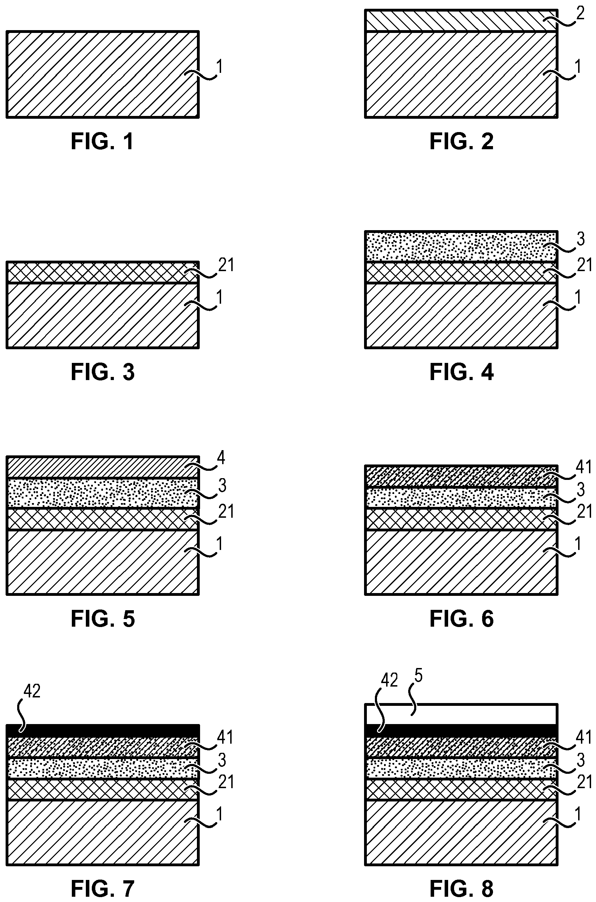

La figure 1 représente la première étape du procédé, qui consiste à fabriquer une pièce 1 en superalliage monocristallin à base de nickel dénué (exempt) d'hafnium.

Cette pièce 1 est par exemple obtenue par fonderie ou fabrication additive et présente la forme souhaitée.

Le tableau 1 ci-dessous représente plusieurs exemples des superalliages susceptibles d'être utilisés dans le procédé conforme à l'invention. Ils sont identifiés par les lettres A à F.

**Tableau 1**

| Exemples de superalliages monocristallins à base de nickel sans hafnium | | | | | | | | | | | |
|---|---|---|---|---|---|---|---|---|---|---|---|
| | **Eléments alliages (pourcentages massiques)** | | | | | | | | | | |
| | **Ni** | **Al** | **Co** | **Cr** | **Mo** | **Re** | **Ta** | **Ti** | **W** | **Cb** | **Ru** |
| A | Reste | 5,2 | 6,5 | 7,8 | 2 | 0 | 7,9 | 1,1 | 5,7 | | |
| B | Reste | 5,6 | 9,6 | 6,5 | 0,6 | 3 | 6,5 | 1 | 6 | | |
| C | Reste | 5,73 | 9,6 | 3,46 | 0,6 | 4,87 | 8,28 | 0,86 | 5,5 | | |
| D | Reste | 5,7 | 3 | 2 | 0,4 | 6 | 8 | 0,2 | 5 | 0,1 | |
| E | Reste | 5,8 | 12,5 | 4,2 | 1,4 | 5,4 | 7,2 | 0 | 6 | | |
| F | Reste | 6 | <0,2 | 4 | 1 | 4 | 5 | 0,5 | 5 | | 4 |

Le terme "reste" correspond, pour chaque superalliage, au pourcentage massique résiduel pour atteindre 100% avec les différents autres composants mentionnés.

La deuxième étape du procédé, représentée sur la figure 2, consiste à déposer sur ladite pièce 1, une première couche 2 comprenant de l'hafnium. De préférence elle présente une épaisseur comprise entre 50 nm et 800 nm, de préférence encore comprise entre 50 nm et 300 nm.

Le dépôt de la première couche 2 d'hafnium peut être réalisé par dépôt chimique en phase vapeur (CVD).

Toutefois, de préférence, il est réalisé par un dépôt physique en phase vapeur (PVD), de préférence encore par pulvérisation cathodique, ce qui permet de bien contrôler les épaisseurs déposées.

Le dépôt PVD s'effectue à l'intérieur d'une enceinte contenant la pièce 1 et une ou plusieurs cibles correspondant au(x) matériau(x) à déposer, ici notamment le hafnium. Sous l'application d'une différence de potentiel entre les parois du réacteur et la (les) cible(s), un plasma se forme dont les espèces positives sont attirées par la cathode (cible) et entrent en collision avec celle(s)-ci. Les atomes de la ou des cible(s) sont pulvérisés et se condensent alors sur la pièce 1.

De préférence, les conditions de dépôt sont les suivantes :
- Chauffage pendant le dépôt : 100°C à 900°C
- Pression : 0,1 Pa à 1 Pa,
- Densité de puissance : 2 à 15 W/cm2,
- Polarisation : - 500 V à -150 V.

Le bombardement ionique est réalisé pendant 10 à 30 minutes entre - 200 V et 500 V.

On procède ensuite à une étape de diffusion de cette première couche de hafnium 2 (voir figure 3), de façon à former à la surface de ladite pièce 1, une première zone d'interdiffusion 21, dans laquelle du hafnium est présent. Bien que cela n'apparaisse pas sur ces figures, Il se peut que toute la couche de hafnium n'ait pas diffusé et qu'il reste au-dessus de la couche d'interdiffusion 21 une fine couche de hafnium.

De préférence, le traitement de diffusion est réalisé en plaçant la pièce 1 recouverte de la première couche 2 d'hafnium à l'intérieur d'une enceinte, en amenant celle-ci sous-vide ou en introduisant à l'intérieur de celle-ci une atmosphère contenant un mélange d'argon et de 5% en volume d'hélium.

Cette enceinte est de préférence différente de celle qui a servi au dépôt mais peut être la même.

La diffusion est ensuite réalisée de préférence comme décrit ci après.

On procède à un traitement thermique qui comprend une phase de montée en température, jusqu'à atteindre une température comprise entre 800°C et 1200°C, ce palier de température étant maintenu pendant une durée de 1 heure à 4 heures.

Ce palier est ensuite suivi d'une étape de refroidissement qui consiste à faire diminuer la température à l'intérieur de l'enceinte jusqu'à retourner à la température ambiante.

La première zone d'interdiffusion 21 ainsi formée permet de protéger la pièce 1 en superalliage monocristallin à base de nickel exempt d'hafnium contre la corrosion et l'oxydation.

La quatrième étape du procédé, représentée sur la figure 4, consiste à déposer sur la première zone d'interdiffusion 21, simultanément ou alternativement, une sous-couche d'un alliage comprenant au moins 10% atomique d'aluminium et de préférence moins de 50% atomique d'aluminium, choisi de préférence parmi NiAlCrSi, NiAlCrSiPt, NiCoAlCrSiPt, NiAl, NiPtAl ou MCrAlY avec M égal au cobalt, au nickel ou au cobalt-nickel, et une deuxième couche comprenant de l'hafnium, de façon à former une couche mixte 3.

De préférence, la sous-couche comprenant au moins 10% atomique d'aluminium est d'une épaisseur comprise entre 5 µm et 30 µm. De préférence également, la deuxième couche comprenant de l'hafnium est d'une épaisseur comprise entre 20 nm et 700 nm.

Lorsque le dépôt est simultané, on obtient un alliage. Ainsi par exemple si la sous-couche est du NiAlPt, alors la couche mixte 3 obtenue sera du NiAlPtHf.

Ce dépôt peut être effectué par l'une des techniques de dépôt précité.

De préférence, il est réalisé par pulvérisation cathodique dans les conditions précitées.

Ce dépôt simultané peut être réalisé en utilisant une cible en hafnium pour le dépôt de la couche d'hafnium et une cible alliée, c'est-à-dire contenant les différents composants de l'alliage que l'on souhaite déposer pour constituer la sous-couche.

Selon une autre variante de réalisation, ce dépôt peut être effectué en utilisant une cible par élément chimique à déposer, par exemple cinq cibles pour un dépôt simultané de NiCrAlY et d'hafnium, (dépôt par copulvérisation).

Le tableau ci-dessous donne différents exemples des couples d'épaisseur de sous-couches et de hafnium susceptibles d'être utilisés.

**Tableau 2**

| | Epaisseurs (µm) | | | |
|---|---|---|---|---|
| Sous-couche | 5 | 10 | 20 | 30 |
| Hafnium | 0,02 - 0,07 | 0,07 - 0,1 | 0,1 - 0,2 | 0,2 - 0,7 |

Le deuxième dépôt de hafnium pendant le dépôt de la sous-couche permet de renforcer les joints de grains de la sous-couche, en bloquant ainsi la diffusion des cations métalliques qui en font partie et en ralentissant la diffusion d'oxygène dans cette dernière et donc la cinétique d'oxydation de la sous-couche. Le rôle de cette couche mixte 3 est d'augmenter la durée de vie de réservoir d'aluminium et la durée de vie de la barrière thermique si elle est formée ultérieurement.

La cinquième étape du procédé, représenté sur la figure 5, consiste à déposer sur ladite couche mixte 3, une troisième couche contenant de l'hafnium 4, d'une épaisseur comprise de préférence entre 10 nm et 100 nm.

De façon avantageuse, ce dépôt est effectué avec les techniques et dans les conditions identiques à celles décrites ci-dessus pour le dépôt de la première couche de hafnium 2.

Enfin, comme représenté sur la figure 6, le procédé consiste à soumettre la pièce 1 à un traitement de diffusion puis d'oxydation.

La diffusion de la troisième couche d'hafnium 4, permet d'obtenir une deuxième zone d'interdiffusion 41. Le traitement de diffusion est avantageusement réalisé selon les mêmes conditions que celles décrites précédemment pour le traitement de diffusion de la première couche d'hafnium 2.

Le traitement d'oxydation, représenté sur la figure 7, permet d'obtenir une couche d'alumine et d'hafnium 42.

Son épaisseur est de préférence comprise entre 200 nm et 700 nm.

Plus précisément, il s'agit d'une couche d'alumine comprenant de l'hafnium dans ses joints de grains, autrement dit une couche d'alumine dopée au niveau de ses joints de grains par du hafnium.

Ce traitement d'oxydation est réalisé à l'intérieur d'une enceinte sous pression partielle d'oxygène ou d'argon.

Les différentes étapes du traitement d'oxydation sont de préférence les suivantes :
- montée en température : de préférence 80°C à 100°C/mn,
- pallier d'oxydation : 0,5 h à 1 h, à une température comprise entre 900°C et 1200°C,
- refroidissement, diminution de température : de préférence 80°C à 100°C/mn.

Enfin, il est également possible sur la couche 42 d'alumine dopée au hafnium de procéder au dépôt d'une couche de barrière thermique 5 (voir figure 8). Cette couche 5 est par exemple de la zircone yttriée ou une multicouche comprenant une céramique et de la zircone yttriée.

On notera que les différentes étapes de dépôt du hafnium et de la sous-couche de diffusion et d'oxydation peuvent être réalisées dans la même machine de dépôt, ce qui simplifie la fabrication.

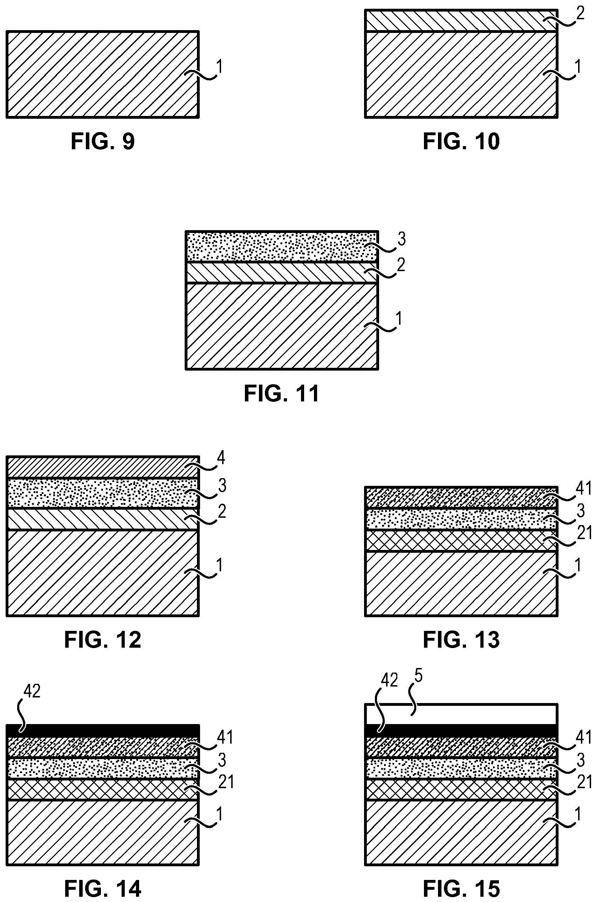

Un deuxième mode de réalisation du procédé conforme à l'invention va maintenant être décrit en liaison avec les figures 9 à 15. Il s'agit d'une variante du premier mode réalisation. En conséquence, les couches ou sous-couches identiques portent les mêmes références numériques.

Les deux premières étapes du procédé représentées sur les figures 9 à 10 sont identiques aux deux premières étapes de la première variante de réalisation, représentées sur les figures 1 et 2.

On procède ensuite à la formation de la couche mixte 3 selon les modalités précemment décrites, mais directement sur la première couche 2 comprenant de l'hafnium (étape représentée sur la figure 11).

On procède ensuite au dépôt sur ladite couche mixte 3, de la troisième couche comprenant de l'hafnium 4 selon les modalités décrites dans le précédent mode de réalisation, comme représenté sur la figure 12.

Après avoir formé ou déposé l'ensemble des couches 2, 3 et 4, on procède alors au traitement de diffusion, de façon à faire diffuser la première couche 2 dans la partie supérieure de la pièce 1 et à y former une première zone d'interdiffusion 21 et de façon à faire diffuser la troisième couche 4 comprenant l'hafnium à la surface de ladite couche mixte 3 et former une deuxième zone d'interdiffusion 41 (voir figure 13). Le traitement de diffusion est identique à celui décrit précédemment dans le premier mode de réalisation. Cette étape est représentée sur la figure 13.

Enfin, les deux dernières étapes du procédé concernant le traitement d'oxydation de la deuxième zone d'interdiffusion 41 et éventuel dépôt de la couche de barrière thermique 5 sur la couche d'alumine 42 précédemment formée sont ensuite réalisées conformément à ce qui a été décrit pour les étapes du premier mode de réalisation. Ces étapes sont représentées respectivement sur les figures 14 et 15.

D'une manière générale, le procédé conforme à l'invention consiste donc à déposer ou former les différentes couches 2, 3, 4 et à réaliser le traitement de diffusion précité. Ce traitement de diffusion peut être réalisé soit après le dépôt de la première couche 2 puis répété après le dépôt de la troisième couche 4, soit être réalisé en une seule fois après le dépôt de l'ensemble des couches.

## Revendications

1. Procédé de protection contre la corrosion et l'oxydation d'une pièce (1) réalisée en superalliage monocristallin à base de nickel, exempt d'hafnium, **caractérisé en ce qu'**il comprend au moins les étapes suivantes consistant à :
- fabriquer une pièce (1) en superalliage monocristallin à base de nickel exempt d'hafnium,
- déposer, sur ladite pièce (1), une première couche (2) comprenant de l''hafnium, puis une sous-couche d'un alliage comprenant au moins 10% atomique d'aluminium et une deuxième couche comprenant de l'hafnium, simultanément ou alternativement, de façon à former une couche mixte (3), et enfin une troisième couche comprenant de l'hafnium (4),
- faire diffuser ladite première couche comprenant de l''hafnium (2), de façon à former dans la partie supérieure de ladite pièce (1) en superalliage monocristallin à base de nickel exempt d'hafnium, une première zone d'interdiffusion (21), et faire diffuser la troisième couche (4) comprenant de l'hafnium, de façon à former à la surface de ladite couche mixte (3), une deuxième zone d'interdiffusion (41),
- après le traitement de diffusion, réaliser un traitement d'oxydation de ladite deuxième zone d'interdiffusion (41), de façon à obtenir une couche d'alumine dopée par de l'hafnium (42), à la surface de ladite deuxième zone d'interdiffusion (41).

2. Procédé selon la revendication 1, **caractérisé en ce qu'**il consiste à réaliser d'abord le dépôt des différentes couches et sous-couche, avant de procéder au traitement de diffusion.

3. Procédé selon la revendication 1, **caractérisé en ce qu'**il comprend au moins les étapes suivantes consistant à :
- fabriquer une pièce (1) en superalliage monocristallin à base de nickel exempt d'hafnium,
- déposer, sur ladite pièce (1), une première couche (2) comprenant de l''hafnium,
- faire diffuser cette première couche comprenant de l''hafnium (2), de façon à former à la surface de ladite pièce (1) en superalliage monocristallin à base de nickel exempt d'hafnium, une première zone d'interdiffusion (21),
- déposer simultanément ou alternativement, sur ladite première zone d'interdiffusion (21), une sous-couche d'un alliage comprenant au moins 10% atomique d'aluminium et une deuxième couche comprenant de l'hafnium, de façon à former une couche mixte (3),
- déposer, sur ladite couche mixte (3), une troisième couche comprenant de l'hafnium (4)
- faire diffuser cette troisième couche (4) comprenant de l'hafnium, de façon à former à la surface de ladite couche mixte (3), une deuxième zone d'interdiffusion (41),
- réaliser un traitement d'oxydation de ladite deuxième zone d'interdiffusion (41), de façon à obtenir une couche d'alumine dopée par de l'hafnium (42), à la surface de ladite deuxième zone d'interdiffusion (41).

4. Procédé selon l'une des revendications précédentes, **caractérisé en ce qu'**il comprend une étape consistant à déposer, sur ladite couche (42) d'alumine dopée par de l'hafnium, une couche de barrière thermique (5).

5. Procédé selon l'une des revendications précédentes, **caractérisé en ce qu'**au moins l'une des étapes de dépôt est réalisée par dépôt physique en phase vapeur PVD, de préférence par pulvérisation cathodique.

6. Procédé selon la revendication 5, **caractérisé en ce que** le dépôt est réalisé par pulvérisation cathodique à une température comprise entre 100°C et 900°C, sous une pression comprise entre 0,1 Pa et 1Pa, avec une densité de puissance comprise entre 2 et 15 W/cm² et une polarisation négative comprise entre -500 V et -150 V et sous un bombardement ionique entre -200V et 500V pendant 10 à 30 minutes.

7. Procédé selon l'une quelconque des revendications précédentes, **caractérisé en ce que** le traitement de diffusion est réalisé par un traitement thermique sous vide ou en présence d'un mélange d'argon et de 5% en volume d'hélium, ce traitement thermique comprenant une étape de montée en température jusqu'à atteindre une température comprise entre 800° C et 1200°C, une étape de maintien de cette température pendant 1 heure à 4 heures et une étape de refroidissement par diminution de la température jusqu'à atteindre la température ambiante.

8. Procédé selon l'une des revendications précédentes, **caractérisé en ce que** le traitement d'oxydation de la deuxième zone d'interdiffusion (41) est réalisé par un traitement thermique sous pression partielle d'oxygène ou d'argon, ce traitement thermique comprenant une étape de montée en température jusqu'à atteindre une température comprise entre 900°C et 1200°C, une étape de maintien de cette température pendant moins d'une heure et une étape de refroidissement jusqu'à atteindre la température ambiante.

9. Procédé selon l'une des revendications précédentes, **caractérisé en ce que** la première couche (2) comprenant du hafnium présente une épaisseur comprise entre 50 nm et 800 nm, de préférence comprise entre 50 nm et 300 nm.

10. Procédé selon l'une des revendications précédentes, **caractérisé en ce que** la sous-couche d'un alliage comprenant au moins 10% atomique d'aluminium est choisie parmi NiAlCrSi, NiAlCrSiPt, NiCoAlCrSiPt, NiAl, NiPtAl ou MCrAlY avec M égal au cobalt, au nickel ou au cobalt-nickel.

11. Procédé selon l'une des revendications précédentes, **caractérisé en ce que** la sous-couche d'un alliage comprenant au moins 10% atomique d'aluminium présente une épaisseur comprise entre 5 µm et 30 µm.

12. Procédé selon l'une des revendications précédentes, **caractérisé en ce que** la deuxième couche comprenant de l'hafnium présente une épaisseur comprise entre 20 nm et 700 nm.

13. Procédé selon l'une des revendications précédentes, **caractérisé en ce que** la troisième couche (4) comprenant de l'hafnium présente une épaisseur comprise entre 10 nm et 100 nm.

## Patentansprüche

1. Verfahren zum Schutz eines Teils (1) aus hafniumfreier einkristalliner Superlegierung auf Nickelbasis vor Korrosion und Oxidation, **dadurch gekennzeichnet, dass** es mindestens die folgenden Schritte umfasst, die bestehen im:
- Herstellen eines Teils (1) aus hafniumfreier einkristalliner Superlegierung auf Nickelbasis,
- Abscheiden einer ersten Schicht (2), die Hafnium umfasst, dann einer Unterschicht aus einer Legierung, die mindestens 10 At.-% Aluminium umfasst, und einer zweiten Schicht, die Hafnium umfasst, gleichzeitig oder abwechselnd, derart dass eine Mischschicht (3) gebildet wird, und schließlich einer dritten Schicht, die Hafnium (4) umfasst, auf dem Teil (1),
- Bewirken des Diffundierens der ersten Schicht, die Hafnium (2) umfasst, derart dass im oberen Abschnitt des Teils (1) aus hafniumfreier einkristalliner Superlegierung auf Nickelbasis eine erste Interdiffusionszone (21) gebildet wird, und Bewirken des Diffundierens der dritten Schicht (4), die Hafnium umfasst, derart dass an der Oberfläche der Mischschicht (3) eine zweite Interdiffusionszone (41) gebildet wird,
- nach der Diffusionsbehandlung, Ausführen einer Behandlung zur Oxidation der zweiten Interdiffusionszone (41), derart dass eine mit dem Hafnium (42) dotierte Aluminiumoxidschicht erhalten wird, auf der Oberfläche der zweiten Interdiffusionszone (41).

2. Verfahren nach Anspruch 1, **dadurch gekennzeichnet, dass** es darin besteht, zuerst das Abscheiden der verschiedenen Schichten und der Unterschicht vor dem Vornehmen der Diffusionsbehandlung auszuführen.

3. Verfahren nach Anspruch 1, **dadurch gekennzeichnet, dass** es mindestens die folgenden Schritte umfasst, die bestehen im:
- Herstellen eines Teils (1) aus hafniumfreier einkristalliner Superlegierung auf Nickelbasis,
- Abscheiden einer ersten Schicht (2), die Hafnium umfasst, auf dem Teil (1),
- Bewirken des Diffundierens dieser ersten Schicht, die Hafnium (2) umfasst, derart dass an der Oberfläche des Teils (1) aus hafniumfreier einkristalliner Superlegierung auf Nickelbasis eine erste Interdiffusionszone (21) gebildet wird,
- gleichzeitiges oder abwechselndes Abscheiden einer Unterschicht aus einer Legierung, die mindestens 10 At.-% Aluminium umfasst, und einer zweiten Schicht, die Hafnium umfasst, derart dass eine Mischschicht (3) gebildet wird, auf der ersten Interdiffusionszone (21),
- Abscheiden einer dritten Schicht, die Hafnium (4) umfasst, auf der Mischschicht (3),
- Bewirken des Diffundierens dieser dritten Schicht (4), die Hafnium umfasst, derart dass auf der Oberfläche der Mischschicht (3) eine zweite Interdiffusionszone (41) gebildet wird,
- Ausführen einer Behandlung zur Oxidation der zweiten Interdiffusionszone (41), derart dass eine mit dem Hafnium (42) dotierte Aluminiumoxidschicht erhalten wird, auf der Oberfläche der zweiten Interdiffusionszone (41) .

4. Verfahren nach einem der vorhergehenden Ansprüche, **dadurch gekennzeichnet, dass** es einen Schritt umfasst, der darin besteht, auf der Schicht (42) aus mit dem Hafnium dotiertem Aluminiumoxid eine Wärmesperrschicht (5) abzuscheiden.

5. Verfahren nach einem der vorhergehenden Ansprüche, **dadurch gekennzeichnet, dass** mindestens einer der Schritte des Abscheidens durch physikalische Gasphasenabscheidung, PVD, vorzugsweise durch Kathodenzerstäubung, ausgeführt wird.

6. Verfahren nach Anspruch 5, **dadurch gekennzeichnet, dass** die Abscheidung durch Kathodenzerstäubung bei einer Temperatur, die zwischen 100°C und 900°C beträgt, unter einem Druck, der zwischen 0,1 Pa und 1 Pa beträgt, mit einer Leistungsdichte, die zwischen 2 und 15 W/cm² beträgt, und einer negativen Polarisation, die zwischen -500 V und -150 V beträgt, und unter einem Ionenbeschuss zwischen -200 V und 500 V während 10 bis 30 Minuten ausgeführt wird.

7. Verfahren nach einem der vorhergehenden Ansprüche, **dadurch gekennzeichnet, dass** die Diffusionsbehandlung durch eine Wärmebehandlung im Vakuum oder bei Vorhandensein einer Mischung aus Argon und 5 Vol.-% Helium ausgeführt wird, wobei diese Wärmebehandlung einen Schritt der Erhöhung der Temperatur, bis eine Temperatur erreicht wird, die zwischen 800°C und 1200°C beträgt, einen Schritt des Aufrechterhaltens dieser Temperatur während 1 bis 4 Stunden und einen Schritt des Abkühlens durch Senkung der Temperatur, bis die Umgebungstemperatur erreicht wird, umfasst.

8. Verfahren nach einem der vorhergehenden Ansprüche, **dadurch gekennzeichnet, dass** die Behandlung zur Oxidation der zweiten Interdiffusionszone (41) durch eine Wärmebehandlung unter Sauerstoff- oder ArgonPartialdruck ausgeführt wird, wobei diese Wärmebehandlung einen Schritt des Erhöhens der Temperatur, bis eine Temperatur erreicht wird, die zwischen 900°C und 1200°C beträgt, einen Schritt des Aufrechterhaltens dieser Temperatur während mindestens einer Stunde und einen Schritt des Abkühlens, bis die Umgebungstemperatur erreicht wird, umfasst.

9. Verfahren nach einem der vorhergehenden Ansprüche, **dadurch gekennzeichnet, dass** die erste Schicht (2), die Hafnium umfasst, eine Dicke aufweist, die zwischen 50 nm und 800 nm beträgt, vorzugsweise zwischen 50 nm und 300 nm beträgt.

10. Verfahren nach einem der vorhergehenden Ansprüche, **dadurch gekennzeichnet, dass** die Unterschicht aus einer Legierung, die mindestens 10 At.-% Aluminium umfasst, unter NiAlCrSi, NiAlCrSiPt, NiCoAlCrSiPt, NiAl, NiPtAl oder MCrAlY gewählt wird, wobei M gleich Kobalt, Nickel oder Kobalt-Nickel ist.

11. Verfahren nach einem der vorhergehenden Ansprüche, **dadurch gekennzeichnet, dass** die Unterschicht aus einer Legierung, die mindestens 10 At.-% Aluminium umfasst, eine Dicke aufweist, die zwischen 5 µm und 30 µm beträgt.

12. Verfahren nach einem der vorhergehenden Ansprüche, **dadurch gekennzeichnet, dass** die zweite Schicht, die Hafnium umfasst, eine Dicke aufweist, die zwischen 20 nm und 700 nm beträgt.

13. Verfahren nach einem der vorhergehenden Ansprüche, **dadurch gekennzeichnet, dass** die dritte Schicht (4), die Hafnium umfasst, eine Dicke aufweist, die zwischen 10 nm und 100 nm beträgt.

## Claims

1. A process for protecting a hafnium-free nickel-based single-crystal superalloy part (1) against corrosion and oxidation, **characterized in that** it comprises at least the following steps consisting in:
- manufacturing a hafnium-free nickel-based single-crystal superalloy part (1),
- depositing, on said part (1), a first layer (2) comprising hafnium, then an undercoat of an alloy comprising at least 10 atomic % aluminium and a second layer comprising hafnium, simultaneously or alternately, so as to form a mixed layer (3), and finally a third layer comprising hafnium (4),
- diffusing said first layer comprising hafnium (2), so as to form a first interdiffusion zone (21) in the upper part of said hafnium-free nickel-based single-crystal superalloy part (1), and diffusing the third layer (4) comprising hafnium, so as to form a second interdiffusion zone (41) on the surface of said mixed layer (3),
- after the diffusion treatment, carrying out an oxidation treatment of said second interdiffusion zone (41), so as to obtain a layer of hafnium-doped alumina (42) on the surface of said second interdiffusion zone (41).

2. The process according to claim 1, **characterized in that** it consists in first depositing the various layers and undercoat before carrying out the diffusion treatment.

3. The process according to claim 1, **characterized in that** it comprises at least the following steps consisting in:
- manufacturing a hafnium-free nickel-based single-crystal superalloy part (1),
- depositing, on said part (1), a first layer (2) comprising hafnium,
- diffusing this first layer comprising hafnium (2), so as to form a first interdiffusion zone (21) on the surface of said hafnium-free nickel-based single-crystal superalloy part (1),
- simultaneously or alternately depositing, on said first interdiffusion zone (21), an undercoat of an alloy comprising at least 10 atomic % aluminium and a second layer comprising hafnium, so as to form a mixed layer (3),
- depositing, on said mixed layer (3), a third layer comprising hafnium (4)
- diffusing said third layer (4) comprising hafnium, so as to form a second interdiffusion zone (41) on the surface of said mixed layer (3),
- carrying out an oxidation treatment of said second interdiffusion zone (41), so as to obtain a layer of hafnium-doped alumina (42) on the surface of said second interdiffusion zone (41).

4. The process according to one of the preceding claims, **characterized in that** it comprises a step consisting in depositing, on said layer of hafnium-doped alumina (42), a thermal barrier layer (5).

5. The process according to one of the preceding claims, **characterized in that** at least one of the deposition steps is carried out by physical vapour deposition (PVD), preferably by cathode sputtering.

6. The process according to claim 5, **characterized in that** the deposition is carried out by cathode sputtering at a temperature comprised between 100°C and 900° C, under a pressure comprised between 0.1Pa and 1Pa, with a power density comprised between 2 and 15 W/cm² and a negative polarization comprised between -500 V and -150 V and under ionic bombardment between -200V and 500V for 10 to 30 minutes.

7. The process according to any one of the preceding claims, **characterized in that** the diffusion treatment is carried out by heat treatment under vacuum or in the presence of a mixture of argon and 5% by volume helium, this heat treatment comprising a step of temperature increase until a temperature comprised between 800°C and 1200°C is reached, a step of maintaining this temperature for 1 hour to 4 hours and a step of cooling by decreasing the temperature until room temperature is reached.

8. The process according to one of the preceding claims, **characterized in that** the oxidation treatment of the second interdiffusion zone (41) is carried out by heat treatment under partial pressure of oxygen or argon, this heat treatment comprising a step of temperature increase until a temperature comprised between 900°C and 1200°C is reached, a step of maintaining this temperature for less than one hour and a step of cooling until room temperature is reached.

9. The process according to one of the preceding claims, **characterized in that** the first layer (2) comprising hafnium has a thickness comprised between 50 nm and 800 nm, preferably comprised between 50 nm and 300 nm.

10. The process according to one of the preceding claims, **characterized in that** the undercoat of an alloy comprising at least 10 atomic % aluminium is selected from NiAlCrSi, NiAlCrSiPt, NiCoAlCrSiPt, NiAl, NiPtAl or MCrAlY with M equal to cobalt, nickel or cobalt-nickel.

11. The process according to one of the preceding claims, **characterized in that** the undercoat of an alloy comprising at least 10 atomic % aluminium has a thickness comprised between 5 µm and 30 µm.

12. The process according to one of the preceding claims, **characterized in that** the second layer comprising hafnium has a thickness comprised between 20 nm and 700 nm.

13. The process according to one of the preceding claims, **characterized in that** the third layer (4) comprising hafnium has a thickness comprised between 10 nm and 100 nm.
